# EUROPEAN PATENT SPECIFICATION

(11) **EP 2 299 229 B1**
(45) Date of publication and mention of the grant of the patent: **18.01.2012**
(21) Application number: 09011612.0
(22) Date of filing: 10.09.2009
(51) Int. Cl.: F28D 15/02, H01L 23/427

(54) **Plurality of heat pipes and fixing assembly therefor, and heat sink**
Wärmerohren und Befestigungseinheit dafür und Wärmesenke
Caloducs et ensemble de fixation pour ceux-ci et dissipateur de chaleur

(43) Date of publication of application: 23.03.2011
(73) Proprietor: CPUMATE INC., Taipei County 248 (TW); Golden Sun News Techniques Co., Ltd., Taipei County 248 (TW)
(72) Inventor: Lin, Kuo-Len, Wugu Township Taipei County 248 (TW); Lin, Chen-Hsiang, Wugu Township Taipei County 248 (TW); Hsu, Ken, Wugu Township Taipei County 248 (TW); Cheng, Chih-Hung, Wugu Township Taipei County 248 (TW)
(74) Representative: Wagner, Bernhard Peter

(56) References cited:
- US-A1- 2005 067 144
- US-A1- 2007 151 711
- US-A1- 2007 267 181
- US-B1- 7 093 648

## Description

### BACKGROUND OF THE INVENTION

### 1. Field of the Invention

The present invention relates to a heat-conducting structure, and in particular to a combination of heat pipes and a heat-conducting base.

### 2. Description of Prior Art

Taiwan Patent Publication No.M349179 discloses a conventional heat sink having juxtaposed heat pipes, which includes a heat-dissipating body, a heat-conducting base and a plurality of heat pipes. The heat-dissipating body is formed by stacking a plurality of heat-dissipating pieces. The heat pipe has a heat-absorbing end and a condensing end. Each of the heat-dissipating pieces is provided with through-holes. The condensing section of the heat pipe penetrates the thorough-hole of each heat-dissipating piece. The heat-conducting block is provided with a plurality of troughs in which the heat-absorbing ends of the heat pipes can be juxtaposed.

Before the heat-absorbing end of the heat pipe is disposed in the trough, a metallic material of a low melting point has to be applied to the interior of the trough. Then, the heat-absorbing end of the heat pipe is disposed in the trough. Finally, the heat pipe is put into a soldering furnace, so that the applied metallic material can be heated and melted to secure the heat pipe to the heat-conducting block. In this way, a heat sink having heat pipes can be formed. However, the surface of the heat pipe may become black due to the heating of the soldering furnace. As a result, another reduction-and-oxidization (abbreviated as "redox" hereinafter) process has to be executed, thereby making the surface of the heat pipe to return its original color.

The process of manufacturing the above-mentioned heat sink involves the production cost and material cost resulted from the steps of applying and melting heat-conducting medium. Furthermore, during the combination of the heat pipe with the heat-conducting block, the surface of the heat pipe becomes block due to the heating and melting steps of the soldering furnace. As a result, it is necessary to execute another redox process to make the surface of the heat pipe to return its original color, which causes additional cost.

Thus, in order to eliminate the heating and melting steps used in the conventional process, a pressing step is proposed, whereby the juxtaposed heat pipes can be compressed in a trough of the heat-conducting block. However, the step of pressing the heat pipe into the heat-conducting block is more complicated. Also, the surface of the heat pipe after pressing may suffer damage easily, which affects the yield and lifetime of the heat sink. Furthermore, when the heat sink is transported to another place, the heat pipes inserted into the heat-conducting block may be displaced easily due to external forces. The aim of the present invention is to solve the above-mentioned problem.

### SUMMARY OF THE INVENTION

The present invention is to provide a plurality of heat pipes and a fixing assembly for heat-absorbing surfaces of the juxtaposed heat pipes according to claim 1, whereby the step of combining the heat pipes with a fixing base can US 2007/0151711 A1 describes a heat sink and a method for manufacturing the same. Herein, a heat-conducting member comprises a base and a cover connected to the upside of the base. The base is provided with at least one non-opening grooves. The center of each non-opening groove is provided with a hole. The cover is provided to correspond to the base, wherein top ends of the left and right side plates of the cover are provided with horizontally extending plates, respectively. The plate is provided with a plurality of through holes corresponding to the left and right ends of each non-opening groove of the base. The bottom plate of the cover is provided with a plurality of parallel grooves corresponding to the interval of each through hole. be simplified, and thus the production cost and time can be reduced.

The present invention is to provide a plurality of heat pipes and a fixing assembly for heat-absorbing surfaces of the juxtaposed heat pipes, whereby the integrity of the external appearance of the evaporating section of the heat pipe can be maintained, and the yield and lifetime of the heat pipe can be increased.

The present invention provide a plurality of heat pipes and a fixing assembly for heat-absorbing surfaces of juxtaposed heat pipes, whereby the displacement of the heat pipe caused by external forces can be prevented.

The present invention provides a plurality of heat pipes and a fixing assembly for heat-absorbing surfaces of juxtaposed heat pipes, which include a fixing base, a plurality of heat pipes and a fixing body. A bottom surface of the fixing base is provided with a connecting plane. The fixing base extends upwards to form a fixing arm. The fixing arm is provided with a plurality of first grooves. The heat pipe has an evaporating section provided with a contacting plane and an adhering plane. The evaporating sections of the heat pipes are adjacent to each other with their respective contacting planes, and the evaporating sections are fixed to the connecting plane of the fixing base. An upper edge of the evaporating section of the heat pipe is received in the first groove of the fixing arm. The fixing body is combined with the fixing arm. The fixing body is provided with a plurality of second grooves. The second grooves correspond to the first grooves for cooperatively receiving and clamping the upper edges of the evaporating sections of the heat pipes.

The present invention provides a heat sink according to claim 9 having a plurality of heat pipes and a fixing assembly for heat-absorbing surfaces of the juxtaposed heat pipes, which include a fixing base, a plurality of heat pipes, a plurality of fins and a fixing body. A bottom surface of the fixing base is provided with a connecting plane. The fixing base extends upwards to form a fixing arm. The fixing arm is provided with a plurality of first grooves. The heat pipe has an evaporating section and a condensing section. The evaporating section is provided with a contacting plane and an adhering plane. The evaporating sections of the heat pipes are adjacent to each other with their respective contacting planes, and the evaporating sections are fixed to the connecting plane of the fixing base. An upper edge of the evaporating section of the heat pipe is received in the first groove of the fixing arm. The condensing section of the heat pipe penetrates the parallel fins. The fixing body is combined with the fixing arm. The fixing body is provided with a plurality of second grooves. The second grooves correspond to the first grooves for cooperatively receiving and clamping the upper edges of the evaporating sections of the heat pipes.

In comparison with prior art, according to the present invention, the evaporating section of the heat pipe is formed with a contacting plane and an adhering plane, and the evaporating sections of the heat pipes are adjacent to each other and juxtaposed in the fixing base. A fixing arm extends from the fixing base for receiving the upper edge of the evaporating section of the heat pipe. Further, the fixing body is connected to the fixing arm by screw elements, thereby positioning the heat pipe. In this way, the conventional step of fixing the heat pipes by means of melting or pressing can be replaced. Thus, the combining step of the heat pipes with the fixing base can be simplified, and the yield and lifetime of the heat sink having such heat pipes can be increased.

### BRIEF DESCRIPTION OF THE DRAWINGS

FIG. 1 is a schematic view showing the external appearance of the present invention;
FIG. 2 is an exploded perspective view of the present invention;
FIG. 3 is an assembled cross-sectional view showing one side of the present invention;
FIG. 4 is an assembled cross-sectional view showing another side of the present invention;
FIG. 5 is a schematic view showing the combination of the present invention with the heat-dissipating fins; and
FIG. 6 is a view showing the second embodiment of the present invention.

### DETAILED DESCRIPTION OF THE INVENTION

The characteristics and technical contents of the present invention will be described with reference to the accompanying drawings. However, the drawings are illustrative only but not used to limit the present invention.

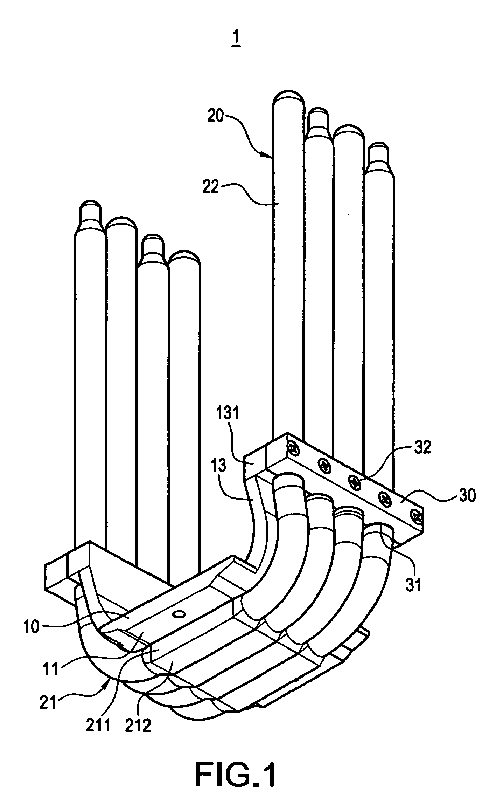

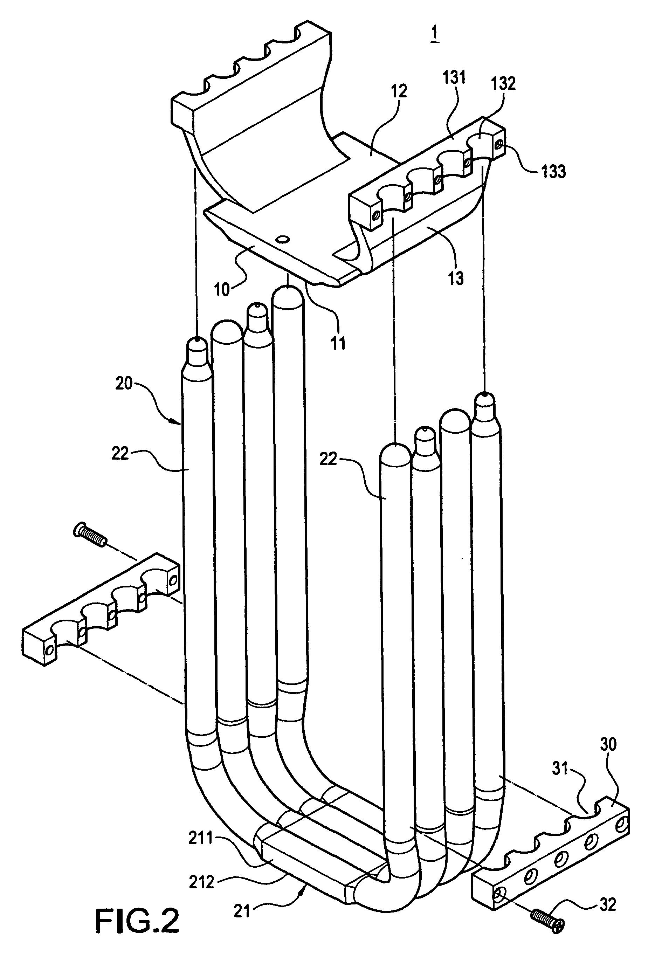

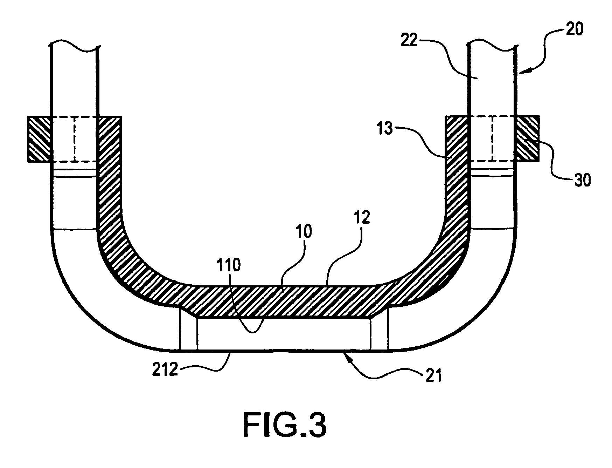

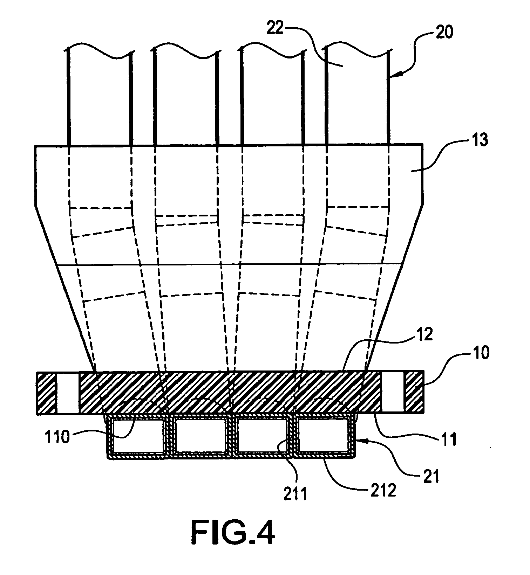

Please refer to FIGS. 1 to 4. FIG. 1 is a schematic view showing the external appearance of the present invention. FIG. 2 is an exploded perspective view of the present invention. FIG.S 3 and 4 are two assembled cross-sectional views of the present invention. The present invention provides a fixing assembly for heat-absorbing surfaces of juxtaposed heat pipes, which includes a fixing base 10, a plurality of heat pipes 20 and a fixing body 30.

The bottom surface 11 of the fixing base 10 is provided with a connecting plane 110. Both sides of the top surface 12 of the fixing base 10 extend upwards to form a fixing arm 13 respectively. That is, the fixing base 10 and the two fixing arms 13 are integrally formed into a U shape. The distal end of the fixing arm 13 extends outwards and vertically to form a protruding plate 131. The protruding plate 131 is provided with a plurality of first grooves 132.

Each of the heat pipes 20 is formed into a U shape and has an evaporating section 21 and two condensing sections 22. The evaporating section 21 is provided with a contacting plane 211 and an adhering plane 212. In the present embodiment, the cross section of the evaporating section 21 of the heat pipe 20 is rectangular. The evaporating sections 21 of the heat pipes 20 are juxtaposed with their contacting planes 211 adjacent to each other, and the evaporating sections 21 are fixed to the connecting plane 110 of the fixing base 10. The adhering planes 212 of the evaporating sections 21 are in flush with each other, so that a heat-generating electronic element can be adhered thereto. Further, heat-conducting paste or heat-conducting glue can be applied between the evaporating sections 21 of the heat pipes 20, thereby increasing the heat-conducting effect of the adjacent heat pipes 20.

After the evaporating section 21 of the heat pipe 20 is adhered to the bottom surface of the fixing base 10, the upper edge of the evaporating section 21 of the heat pipe 20 is received in the first groove 132 of the fixing arm 13. Then, the fixing arm 13 is combined with the fixing body 30. The fixing body 30 is provided with a plurality of second grooves 31. The second grooves 31 correspond to the first grooves 132 of the fixing arm 13 for cooperatively receiving and clamping the upper edges of the evaporating sections 21 of the heat pipes 20. The protruding plate 131 of the distal end of the fixing arm 13 is provided with a plurality of connecting holes 133. The fixing body 30 is provided with a plurality of screw holes corresponding to the connecting holes 133. A plurality of screw elements 32 penetrates the connecting holes 133 and the screw holes respectively, thereby connecting the fixing body 30 to the protruding plate 131 of the fixing arm 13.

After the fixing body 30 and the fixing arm 13 are connected to each other by means of the screw elements 32, the upper edges of the evaporating sections 21 of the heat pipes 20 are clamped and fixed to the fixing arm 13. Thus, the evaporating sections 21 of the heat pipes 20 can be positioned on the connecting plane 110 of the fixing base 10, thereby keeping the thermal contact between the evaporating sections 21 of the heat pipes 20 and the fixing base 10.

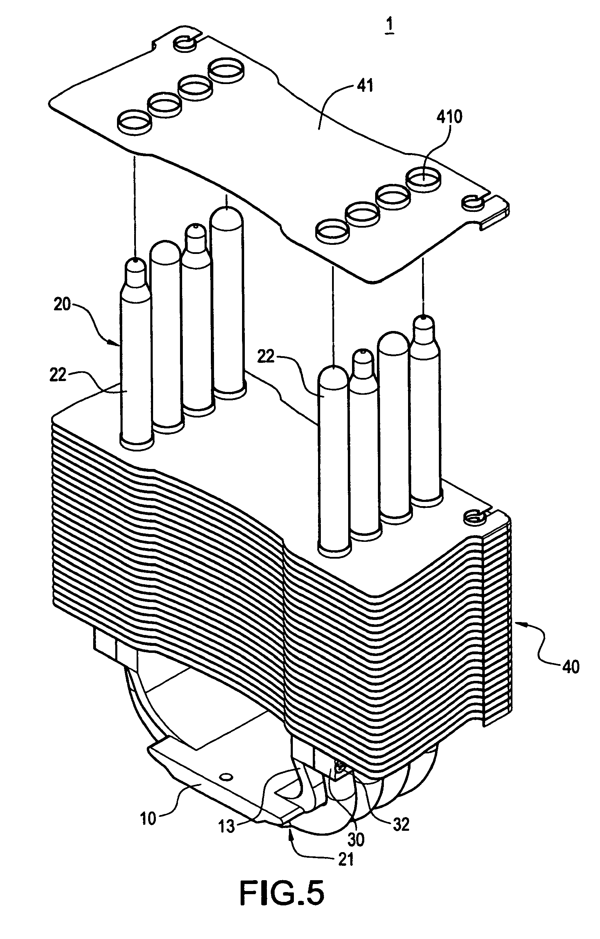

Please refer to FIG. 5. After the heat pipes 20 are assembled with the fixing base 10 and the fixing body 30, the condensing sections 22 of the heat pipes 20 are combined with a plurality of fins 41 to form a heat sink 1. Each of the fins 41 is provided with a plurality of through-holes 410. With the through-holes 410, the condensing sections 22 of the heat pipes 20 can penetrate the respective fins 41 to form a set 40 of heat-dissipating fins, thereby increasing the heat-dissipating area of the heat sink 1 to dissipate the heat rapidly.

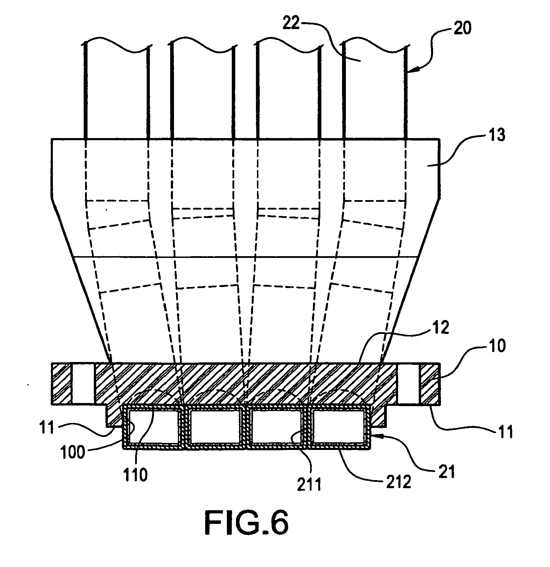

Please refer to FIG. 6, which shows a second embodiment of the fixing assembly for heat-absorbing surfaces of juxtaposed heat pipes according to the present invention. The second embodiment is substantially identical to the first embodiment, but the only difference there between lies in that: the bottom surface 11 of the fixing base 10 is provided with an accommodating trough 100. The top surface of the accommodating trough 100 is the connecting plane 110. The evaporating sections 21 of the heat pipes 20 are juxtaposed and received in the accommodating trough 100. The contacting planes 211 of the evaporating sections 21 are adjacent to each other. The adhering planes 212 used to be adhered to the heat-generating element may protrude from the accommodating trough 100 or be in flush with the accommodating trough 100.

## Claims

1. A plurality of heat pipes and a fixing assembly therefor, comprising:
- a fixing base (10) with its bottom surface (11) having a connecting plane (110), the fixing base (10) extending upwards to form a fixing arm (13), the fixing arm (13) being provided with a plurality of first grooves (132);
- the plurality of juxtaposed heat pipes (20) each having an evaporating section (21) and a condensing section (22), the evaporating section (21) being provided with a contacting plane (211) and an adhering plane (212), the evaporating sections (21) of the heat pipes (20) being adjacent to each other with their respective contacting planes (211), the evaporating sections (21) being fixed to the connecting plane (110) of the fixing base (10), an upper edge of the evaporating section (21) of the heat pipe (20) being received in the first groove (132) of the fixing arm (13); and
- a fixing body (30) combined with the fixing arm (13), the fixing body (30) being provided with a plurality of second grooves (31), the second grooves (31) corresponding to the first grooves (132) for cooperatively receiving and clamping the upper edges of the evaporating sections (21) of the heat pipes (20).

2. The plurality of heat pipes and the fixing assembly therefor according to claim 1, wherein the heat pipe (20) is formed into a U shape and has two condensing sections (22), both sides of the fixing base (10) extend upwards to form the fixing arm (13) respectively, and the two condensing sections (22) are received in the two fixing arms (13) respectively.

3. The plurality of heat pipes and the fixing assembly therefor according to claim 2, wherein the fixing base (10) and the two fixing arms (13) together form a U shape, and the fixing base (10) is integrally formed with the two fixing arms (13).

4. The plurality of heat pipes and the fixing assembly therefor according to claim 2, wherein a distal end of the fixing arm (13) extends outwards and vertically to form a protruding plate (131), the protruding plate (131) is provided with the first grooves (132), the fixing arm (13) is provided with a plurality of connecting holes (133), the fixing body (30) is provided with a plurality of screw holes to correspond to the connecting holes (133).

5. The plurality of heat pipes and the fixing assembly therefor according to claim 1, wherein the bottom surface (11) of the fixing base (10) is provided with an accommodating trough (100), and the top surface of the accommodating trough (100) is the connecting plane (110).

6. The plurality of heat pipes and the fixing assembly therefor according to claim 5, wherein the evaporating sections (21) of the heat pipes (20) are received in the accommodating trough (100), the adhering plane (212) protrudes from the accommodating trough (100).

7. The plurality of heat pipes and the fixing assembly therefor according to claim 1, wherein the evaporating sections (21) of the heat pipes (20) are juxtaposed and fixed to the connecting plane (110) of the fixing base (10), the adhering planes (212) of the evaporating sections (21) are in flush with each other.

8. The plurality of heat pipes and the fixing assembly therefor according to claim 1, wherein the cross section of the evaporating section (21) of the heat pipe is rectangular and applied with heat-conducting paste.

9. A heat sink having a plurality of heat pipes and a fixing assembly therefor according to one of the preceding claims, comprising a plurality of fins (41) arranged parallel and penetrated by the condensing sections (22) of the heat pipes (20).

## Patentansprüche

1. Vielzahl von Wärmerohren und Befestigungsanordnung dafür, mit:
- einer Befestigungsbasis (10), deren Bodenfläche (11) eine Verbindungsebene (110) aufweist, wobei die Befestigungsbasis (10) sich nach oben erstreckt, um einen Befestigungsarm (13) auszubilden, und wobei der Befestigungsarm (13) mit einer Vielzahl von ersten Rillen (132) versehen ist;
- einer Vielzahl von gegenüberliegenden Wärmerohren (20), die jeweils einen Verdampfungsabschnitt (21) und einen Kondensationsabschnitt (22) aufweisen, wobei der Verdampfungsabschnitt (21) mit einer Kontaktebene (211) und einer Anhaftebene (212) versehen ist, wobei die Verdampfungsabschnitte (21) der Wärmerohre (20) mit ihren entsprechenden Kontaktebenen (211) zueinander angrenzen, wobei die Verdampfungsabschnitte (21) an der Verbindungsebene (110) der Befestigungsbasis (10) befestigt sind, und wobei ein oberer Rand des Verdampfungsabschnitts (21) des Wärmerohres (20) in der ersten Rille (132) des Befestigungsarms (13) aufgenommen ist; und
- einem Befestigungskörper (30), der mit dem Befestigungsarm (13) verbunden ist, wobei der Befestigungskörper (30) mit einer Vielzahl von zweiten Rillen (31) versehen ist, und wobei die zweiten Rillen (31) zu den ersten Rillen (132) korrespondieren, um zusammen die oberen Ränder der Verdampfungsabschnitte (21) der Wärmerohre (20) aufzunehmen und einzuklemmen.

2. Vielzahl der Wärmerohre und Befestigungsanordnung dafür nach Anspruch 1, wobei das Wärmerohr (20) in einer U-Form ausgebildet ist und zwei Kondensationsabschnitte (22) aufweist, wobei die Seiten der Befestigungsbasis (10) sich nach oben erstrecken, um jeweils den Befestigungsarm (13) auszubilden, und wobei die zwei Kondensationsabschnitte (22) jeweils in den zwei Befestigungsarmen (13) aufgenommen sind.

3. Vielzahl von Wärmerohren und Befestigungsanordnung dafür nach Anspruch 2, wobei die Befestigungsbasis (10) und die zwei Befestigungsarme (13) zusammen eine U-Form bilden, und wobei die Befestigungsbasis (10) integral mit den zwei Befestigungsarmen (13) ausgebildet ist.

4. Vielzahl von Wärmerohren und Befestigungsanordnung dafür nach Anspruch 2, wobei ein distales Ende des Befestigungsarms (13) sich nach außen und vertikal erstreckt, um eine vorragende Platte (131) auszubilden, wobei die vorragende Platte (131) mit den ersten Rillen (132) versehen ist, der Befestigungsarm (13) mit einer Vielzahl von Verbindungslöchern (133) versehen ist, und der Befestigungskörper (30) mit einer Vielzahl von Schraublöchern versehen ist, die mit den Verbindungslöchern (133) korrespondieren.

5. Vielzahl von Wärmerohren und Befestigungsanordnung dafür nach Anspruch 1, wobei die Bodenfläche (11) der Befestigungsbasis (10) mit einem Aufnahmegraben (100) versehen ist, und die obere Fläche des Aufnahmegrabens (100) die Verbindungsebene (110) bildet.

6. Vielzahl von Wärmerohren und Befestigungsanordnung dafür nach Anspruch 5, wobei die Verdampfungsabschnitte (21) der Wärmerohre (20) in dem Aufnahmegraben (100) aufgenommen sind, und wobei die Anhaftebene (212) aus dem Aufnahmegraben (100) hervorragt.

7. Vielzahl von Wärmerohren und Befestigungsanordnung dafür nach Anspruch 1, wobei die Verdampfungsabschnitte (21) der Wärmerohre (20) der Verbindungsebene (119) der Befestigungsbasis (10) gegenüberliegen und daran befestigt sind, wobei die Anhaftebenen (212) der Verdampfungsabschnitte (21) bündig zueinander sind.

8. Vielzahl von Wärmerohren und Befestigungsanordnung dafür nach Anspruch 1, wobei der Querschnitt des Verdampfungsabschnitts (21) des Wärmerohres rechteckig und mit Wärmeleitpaste versehen ist.

9. Wärmesenke mit einer Vielzahl von Wärmerohren und einer Befestigungsanordnung dafür nach einem der vorstehenden Ansprüche, mit einer Vielzahl von Lamellen (41), die parallel angeordnet sind und von den Verdampfungsabschnitten (22) der Wärmerohre (20) durchdrungen werden.

## Revendications

1. Pluralité de tubes caloporteurs et assemblage de fixation pour ceux-ci, comprenant :
- une base de fixation (10) dont la surface inférieure (11) présente un plan de connexion (110), la base de fixation (10) s'étendant vers le haut pour former un bras de fixation (13), le bras de fixation (13) étant pourvu d'une pluralité de premières rainures (132) ;
- la pluralité de tubes caloporteurs juxtaposés (20) ayant chacun un tronçon d'évaporation (21) et un tronçon de condensation (22), le tronçon d'évaporation (21) étant pourvu d'un plan de contact (211) et d'un plan d'adhérence (212), les tronçons d'évaporation (21) des tubes caloporteurs (20) étant adjacents les uns aux autres avec leurs plans de contacts respectifs (211), les tronçons d'évaporation (21) étant fixés au plan de connexion (110) de la base de fixation (10), un bord supérieur du tronçon d'évaporation (21) du tubes caloporteurs (20) étant reçu dans la première rainure (132) du bras de fixation (13) ; et
- un corps de fixation (30) combiné avec le bras de fixation (13), le corps de fixation (30) étant pourvu d'une pluralité de secondes rainures (31), les secondes rainures (31) correspondant aux premières rainures (132) pour recevoir et serrer en coopération les bords supérieurs des tronçons d'évaporation (21) des tubes caloporteurs (20).

2. Pluralité de tubes caloporteurs et assemblage de fixation pour ceux-ci selon la revendication 1, dans laquelle le tube caloporteur (20) est formé sous une forme en U et comprend deux tronçons de condensation (22), les deux côtés de la base de fixation (10) s'étendent vers le haut pour former le bras de fixation (13) respectivement, et les deux tronçons de condensation (22) sont reçus dans les deux bras de fixation (13) respectivement.

3. Pluralité de tubes caloporteurs et assemblage de fixation pour ceux-ci selon la revendication 2, dans laquelle la base de fixation (10) et les deux bras de fixation (13) forment ensemble une forme en U, et la base de fixation (10) est intégralement formée avec les deux bras de fixation (13).

4. Pluralité de tubes caloporteurs et assemblage de fixation pour ceux-ci selon la revendication 2, dans laquelle une extrémité distale du bras de fixation (13) s'étend vers l'extérieur et verticalement pour former une plaque en projection (131), la plaque en projection (131) est pourvue des premières rainures (132), le bras de fixation (13) est pourvu d'une pluralité de trous de connexion (133), et le corps de fixation (30) est pourvu d'une pluralité de trous à vis pour correspondre avec les trous de connexion (133).

5. Pluralité de tubes caloporteurs et assemblage de fixation pour ceux-ci selon la revendication 1, dans laquelle la surface inférieure (11) de la base de fixation (10) est pourvue d'une auge de logement (100), et la surface supérieure de l'auge de logement (100) est le plan de connexion (110).

6. Pluralité de tubes caloporteurs et assemblage de fixation pour ceux-ci selon la revendication 5, dans laquelle les tronçons d'évaporation (21) des tubes caloporteurs (20) sont reçus dans l'auge de logement (100), et le plan d'adhérence (212) se projette depuis l'auge de logement (100).

7. Pluralité de tubes caloporteurs et assemblage de fixation pour ceux-ci selon la revendication 1, dans les laquelle les tronçons d'évaporation (21) des tubes caloporteurs (20) sont juxtaposés et fixés au plan de connexion (110) de la base de fixation (10), et les plans d'adhérence (212) des tronçons d'évaporation (21) sont en affleurement les uns avec les autres.

8. Pluralité de tubes caloporteurs et assemblage de fixation pour ceux-ci selon la revendication 1, dans laquelle la section transversale du tronçon d'évaporation (21) du tube caloporteur est rectangulaire et appliquée avec une pâte thermoconductrice.

9. Dispositif d'évacuation de chaleur ayant une pluralité de tubes caloporteurs et un assemblage de fixation pour ceux-ci selon l'une des revendications précédentes, comprenant une pluralité d'ailettes (41) agencées parallèlement et pénétrées par les tronçons de condensation (22) des tubes caloporteurs (20).
